Europäisches Patentamt

European Patent Office

Office européen des brevets

(11) Publication number: 0 509 658 A1

# EUROPEAN PATENT APPLICATION

(21) Application number: 92302610.8

(22) Date of filing: 26.03.92

(51) Int. Cl.5: H01L 21/90

(30) Priority: 01.04.91 US 678484

(43) Date of publication of application:
21.10.92 Bulletin 92/43

(84) Designated Contracting States:
DE FR GB

(71) Applicant: AMERICAN TELEPHONE AND
TELEGRAPH COMPANY
550 Madison Avenue
New York, NY 10022(US)

(72) Inventor: Bollinger, Cheryl Anne
377 Dietrich Valley Road
Kutztown, Pennsylvania 19530(US)
Inventor: Olasupo, Kolawole Rahman
439 East Walnut Street, Box Nr. 556
Kutztown, Pennsylvania 19530(US)

(74) Representative: Johnston, Kenneth Graham et
al
AT&T (UK) LTD. AT&T Intellectual Property
Division 5 Mornington Road
Woodford Green Essex, IG8 OTU(GB)

(54) Planarized tapered via process.

(57) Windows, including those on upper levels, are formed and filled with metal (17) by a method which patterns a resist (15) to expose portions of the dielectric (13) and then uses a planarizing etchback to open the windows. Tapering of the windows is obtained which is typically greatest for the implant aspect ratio windows because the resist is generally thinnest where the dielectric is thickest and vice versa.

FIG. 3

FIG. 5

EP 0 509 658 A1

## Technical Field

This invention relates to semiconductor integrated circuit processing which forms vias which may be on upper levels of metallization.

## Background of the Invention

The complexity of large scale integrated circuits makes it difficult to form all of the electrical interconnections between and to the circuit components with a single level of metallization. Accordingly, methods have been developed which use two or more levels of metallization. The underlying metallization is typically contacted through a dielectric layer which has been patterned to form windows or vias which expose selected portions of the underlying substrate, i.e., of the underlying metallization. The term *substrate* is used to mean any material which lies underneath and supports another material. The windows are filled with metal to make the contact to selected portions of the underlying metallization. Windows are frequently referred to as vias.

Although the described process is conceptually simple, problems arise in implementation. For example, as device dimensions decrease, the aspect ratio of the windows increases because the horizontal dimensions decrease more rapidly than does the vertical dimension. The aspect ratio is the ratio of the horizontal to vertical dimensions. Aluminum is the most commonly used metal in silicon integrated circuit fabrication and is typically deposited by sputtering. However, aluminum forms re-entrant angles which make complete filling of the high aspect windows difficult.

One approach to solving the problem of re-entrant angles tapers the windows so that they are wider at their tops than they are at their bottoms. One embodiment of this approach deposits a resist on top of the dielectric and then patterns the resist and partially etches the dielectric. The resist is then stripped and etching continued with an etch that tapers the window as etching of the window continues. Another embodiment of this approach uses two dielectric layers having different characteristics so that the top layer etches faster than does the bottom layer. Tapering of the windows results. See, e.g., *United States Patent 4,676,869 issued on June 30, 1987 to K-H Lee and Samuel Polanco.* Another variation deposits first and second dielectric layers and etches tapered windows through a selectively deposited resist. The windows are filled with metal and coated with resist. A resist etchback, i.e., a planarizing etch that removes resist and the second dielectric at approximately the same rate, is performed to yield a nominally planar dielectric surface. See, *United States Patent*

4,789,257 *issued on November 7, 1989 to Patrick.*

Forming the windows is frequently made more difficult than might be expected because the topography underlying the dielectric is nonplanar and the dielectric layer has different thicknesses. The etching process used to form the windows must make sure than the deepest windows are fully opened but that the material underlying the shallowest windows is not severely etched. One approach deposits an etch stop layer underneath the dielectric. See, e.g., *United States Patent 4,933,297 issued on June 12, 1990 to C.Y. Lu.* Of course, a planar dielectric surface is desirable because it minimizes problems that non-planar surfaces might create in subsequent processing steps.

Other methods of forming windows in dielectrics which overcome aspects of the problems described are still desired.

## Summary of the Invention

A method of integrated circuit fabrication forms electrical connections by fabricating features on the surface of a substrate and depositing a dielectric layer to cover the features. A resist then covers the surface of the dielectric and is patterned to expose selected portions of the dielectric layer. An etchback then opens windows in the dielectric which expose selected portions of the underlying features and also produces tapering. The etchback is typically a planarizing etchback, i.e., an etch that removes the dielectric and resist at approximately the same rate. The tapering is typically greatest for the shallowest windows because the resist is typically shallowest over the highest portions of the dielectric. The features may be upper level metallizations or device elements.

On one embodiment, the dielectric is partially etched prior to the planarizing etch. In a preferred embodiment, the windows are filled with metal. In another preferred embodiment, the windows are in upper level dielectrics.

## Brief Description of the Drawing

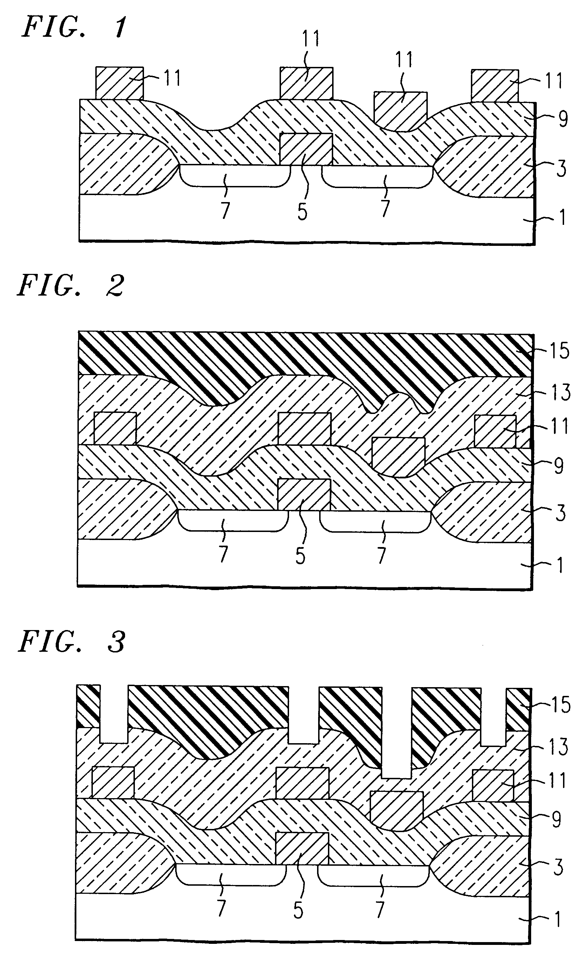

FIGs. 1-5 are sectional views of a portion of an exemplary integrated circuit at several stages of fabrication according to one embodiment of this invention.

For reasons of clarity, the elements depicted are not drawn to scale.

## Detailed Description

The invention will be described with respect to a particular upper level window process, i.e., a process that forms electrical contacts to the first level metallization. Variations and other embodiments will then be readily apparent to those skilled in the art.

FIG. 1 depicts substrate 1, field oxide regions 3, gate structure 5, source/drain regions 7, first dielectric layer 9, and first metallization layer 11. The structure depicted will be readily fabricated by those skilled in the art using well known techniques. Appropriate materials will also be readily selected by those skilled in the art. Several comments are, however, desirable. The individual elements of the gate structure are well known and are not depicted. The field oxide regions provide electrical isolation between devices; other isolation techniques are also possible. As depicted, the first metallization layer has been patterned and it is desired to contact selected portions of the patterned metallization 11. That is, metallization 11 is formed by features on layer 9 which may be termed a substrate.

A second dielectric layer 13 is deposited and coated with a resist 15. An exemplary dielectric is PETEOS (plasma enhanced TEOS). Other dielectrics may also be used. The thickness is not critical, but 2.5 $\mu$m is a typical thickness. The dielectric does not have a planar surface. The resulting structure is depicted in FIG. 2.

The resist is now patterned to form openings which expose selected portions of the underlying, i.e., second, dielectric layer 13. Portions of the exposed dielectric are desirably etched at this point to facilitate full window etching and maintenance of the window size. The resulting structure, with portions of the dielectric etched, is depicted in FIG. 3.

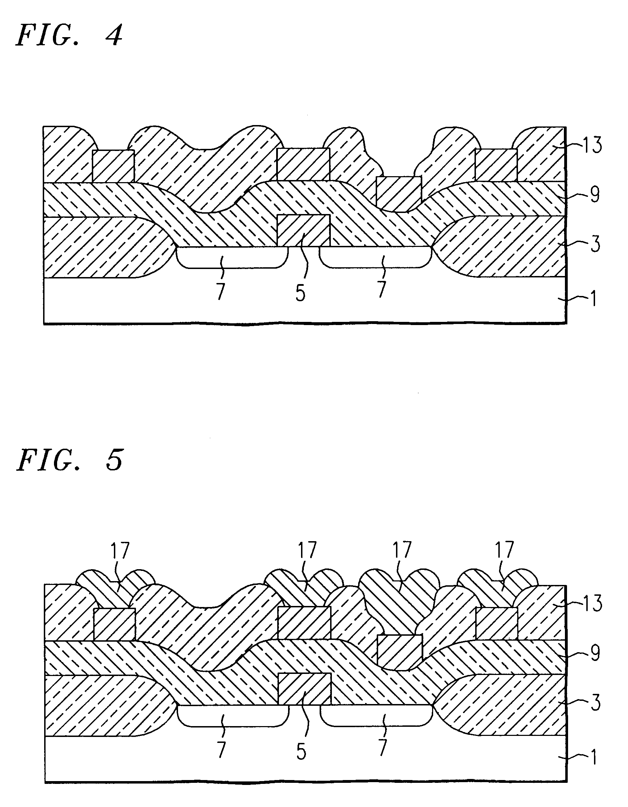

A planarization etch is now used, i.e., an etch which removes dielectric and resist at approximately the same rate. Tapering of the windows is produced because the dielectric begins to etch as soon as the overlying resist is removed. After the windows have been opened, i.e., selected portions of the metallization have been exposed, the resist is stripped. The resulting structure is depicted in FIG. 4. As can be seen, the windows are tapered and some dielectric planarization occurred.

Metal layer 17 is now deposited in the windows and the metal on the surface patterned to leave the windows filled. Conventional deposition techniques can be used. The resulting structure is depicted in FIG. 5.

Other variations will be readily thought of by those skilled in the art. For example, the process described may be repeated, i.e., used to form electrical connections between the third and second levels of metallization, etc. Additionally, the process described may be used to contact device elements, e.g., source/drain regions, through a patterned dielectric layer which exposes selected portions of these elements.

## Claims

1. A method of integrated circuit fabrication comprising the steps of fabricating features(e.g. 11) on the surface of a substrate(1,11);
   depositing a dielectric layer(e.g. 13) which covers said features(e.g. 1,11), said layer having a nonplanar surface;
   depositing a resist(e.g. 15) to cover said surface of said dielectric(e.g. 13);
   patterning said resist(e.g. 15) to form openings with vertical sidewalls which expose selected portions of the said dielectric(e.g. 13); and,
   etching said dielectric(e.g. 13) and said resist(e.g. 15) through said openings with vertical sidewalls CHARACTERIZED IN THAT said etching is with a planarizing etch which opens windows which expose selected portions of said substrate(e.g. 1,11) and partially planarizes said dielectric, said windows having different heights.

2. A method as recited in claim 1 comprising the further step of depositing metal in said windows.

3. A method as recited in claim 2 in which said patterning step etches portions of said dielectric(e.g. 13).

4. A method as recited in claim 3 in which said substrate comprises(e.g. 1,11) an upper level metallization(e.g. 11).

5. A method as recited in claim 3 in which said substrate(e.g. 1) comprises a device element.

6. A method as recited in claim 2 in which said etching is a planarizing etch.

7. A method as recited in claim 1 in which said windows are tapered.

*FIG. 1*

*FIG. 2*

*FIG. 3*

*FIG. 4*

*FIG. 5*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | IBM TECHNICAL DISCLOSURE BULLETIN. vol. 32, no. 4A, September 1989, NEW YORK US pages 167 - 169; 'Simultaneous contact/planarization etch process' * the whole document * | 1-7 | H01L21/90 |
| A | IBM TECHNICAL DISCLOSURE BULLETIN. vol. 32, no. 8B, January 1990, NEW YORK US pages 443 - 445; 'Postsloped vias' * the whole document * | 1-7 | |
| A | EP-A-0 375 501 (THOMSON COMPOSANTS MILITAIRES ET SPATIAUX) * the whole document * | 1-7 | |
| | | | **TECHNICAL FIELDS SEARCHED (Int. Cl.5)** |
| | | | H01L |

The present search report has been drawn up for all claims

| Place of search | Date of completion of the search | Examiner |
|---|---|---|
| BERLIN | 27 JULY 1992 | ROUSSEL A.T. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)